Europäisches Patentamt

European Patent Office

Office européen des brevets

(19)

(11) Publication number: **0 245 559 B1**

(12)

# EUROPEAN PATENT SPECIFICATION

(45) Date of publication of patent specification: **06.11.91**

(51) Int. Cl.⁵: **C08G 59/68**, C08G 59/58, C09D 133/04, C09D 163/00

(21) Application number: **86309133.6**

(22) Date of filing: **21.11.86**

(54) **Two component curable epoxy resin composition having a long pot life.**

(30) Priority: **26.11.85 US 801984**

(43) Date of publication of application:
**19.11.87 Bulletin 87/47**

(45) Publication of the grant of the patent:
**06.11.91 Bulletin 91/45**

(84) Designated Contracting States:
**DE GB IT SE**

(56) References cited:
**EP-A- 0 077 096**
**FR-A- 2 510 130**
**GB-A- 1 484 797**
**US-A- 4 410 680**

(73) Proprietor: **LOCTITE CORPORATION**
**705 North Mountain Road**
**Newington, Connecticut 06111(US)**

(72) Inventor: **Nativi, Larry A.**
**245 Annes Court**
**Rocky Hill Connecticut 06067(US)**
Inventor: **Kropp, Philip L.**
**52 Little Brook Drive**
**Newington Connecticut 06111(US)**

(74) Representative: **Marchant, James Ian et al**
**Elkington and Fife Prospect House 8 Pembroke Road**
**Sevenoaks, Kent TN13 1XR(GB)**

## Description

In U.S. Patents 4,051,195 and 4,181,645 there are described compositions of diamines or polyamines, poly(meth)acrylic esters and polyepoxide resins. These compositions rely on rapid Michael addition between the amine and the acrylic esters to cure the acrylic portion of the composition.

In U.S. 4,410,680 there are described heat curable resins comprising a blend of:

(a) 100 parts by weight of a polyepoxide, particularly a normally liquid polyepoxide and more particularly a glycidyl polyether of a polyhydric phenol,

(b) From about 10 to about 200 parts per weight of at least one ethylenically unsaturated monomer, especially an aromatic monomer, and preferably styrene,

(c) A curing amount of an aliphatic or cycloaliphatic polyfunctional amine or polyamide, and

(d) An effective amount of an amine - compatible peroxide free - radical initiator. This reference states further that the selection of the amine and the peroxy compounds should preferably be one wherein the particular amine tends to start the cure of the epoxy groups before the peroxy initiates the vinyl polymerization at the temperatures employed. The system is a single stage cure system and there is no discussion of competitive acrylic cure rates between Michael addition of amine to the acrylic groups and peroxy initiated free radical cure of those groups.

The present invention, like the prior art references above, is a composition of epoxy, amine, and acrylic functional compounds. However, the invention differs from the prior art in that the composition further comprises a free radical photoinitiator and the amine portion of the composition is limited to theose for which Michael addition to the acrylic resin is relatively slow at ambient temperatures giving a product in which the amine-epoxy reaction is the predominant amine reaction. Examples of the amine portion include polyoxyalkylene polyamines having a molecular weight of about 200 or above, preferably polyoxypropylene polyamines having molecular weights of about 200-6, 500, and/or tertiary amines which catalyze epoxy homopolymerization such as 2,4,6-tri-(dimethylaminomethyl)phenol.

Accordingly the present invention provides a two-part curable composition, characterised by first part comprising (a) a resin mixture comprising 60-95% of compounds having epoxy function groups and 5-40% of compounds having acrylate or methacrylate ester groups; and (b) 0.5-5% based on resin mixture weight of a free radical photoinitiator, and a second part comprising an amine component the amine being selected from those in which the amine-epoxy reaction is predominant amine reaction.

The compositions are characterised by UV surface cures in less than a minute, typically 10-20 seconds with commercial UV curing equipment; a long pot life, at least 1-2 hours, typically 4-8 hours; a shadow cure at ambient temperature where UV light does not penetrate; little or no exotherm; and use of amines which have relatively low handling hazard.

A further aspect of the invention comprises applying a composition as described above as a coating or potting layer on a substrate having shadow areas inaccessible to UV irradiation, irradiating the composition on the substrate with UV light to immobilize the composition and then permitting the composition to completely cure under ambient conditions.

The compositions and method have particular utility in electronics applications. The compositions are particularly suited for use as environmentally protected coatings for electronic circuit boards and as potting materials for electronic components such as potentiometers and the like which utilize thermal plastic housing materials such as polybutylene terephthalate.

The composition of the invention is maintained prior to use as a two-part composition. The first part comprises a resin mixture comprising 60-95% by weight of compounds having epoxy functional groups, preferably 70-85%, and 5-40% of compounds having plural (meth)acrylic ester functional groups, preferably 15-30%. The first part further comprises 0.5-5%, preferably 1-3% based on the weight of the resin mixture, of a free radical photoinitiator. The second part comprises the amine resin, preferably 75-100% of polyoxyalkylene diamine and 0-25% of tertiary amine.

The epoxide resins useful in this invention comprise those compounds having an average of more than 1 vicinal epoxy or oxirane group per molecule.

The polyepoxides may be saturated or unsaturated, aliphatic, cycloaliphatic, aromatic or heterocyclic and may be substituted if desired with noninterferring substituents such as halogen atoms, hydroxyl groups, ether radicals, and the like. They may also be monomeric or polymeric. Suitable polyepoxide compounds are described in the aforementioned U.S. Patents 4,051,195 and 4,410,680. Particularly preferred epoxy resins are glycidyl polyethers of polyhydric phenols, particularly the glycidyl polyether of Bisphenol A.

The term "(meth)acrylate ester" as used herein includes esters of both acrylic and methacrylic acids. Suitable poly(meth)acrylate ester compounds are also described in U.S. 4,051,195 and include (meth)acrylic esters of alkylene glycols, alkoxylene glycols and various other polyhydric alcohols, and reaction products

EP 0 245 559 B1

of epoxide resins and acrylic or methacrylic acid. Urethane acrylic resins may also be used. Preferred are acrylic eaters of polyhydric alcohols such as ethoxylated trimethylolpropane triacrylate.

The amines are selected from those for which Michael addition to the acrylic resin is relatively slow at ambient temperatures giving a product in which the amine-epoxy reaction is the predominant amine reaction and has a pot life after mixing of at least 1 hour. This extended pot life permits the composition to be mixed in bulk, applied to substrates and irradiated to polymerize the acrylic portion of the composition under practical industrial conditions. Preferred amines include polyoxypropylene diamines of molecular weight 200-about 6,500, such as Jeffamine(R) D230, D400, D2000 and 5000 sold by Texaco.

A suitable tertiary amine is 2,4,6-tri-(dimethylaminomethyl)phenol (DMP-30). Other polyfunctional tertiary amines known in the epoxy catalyst art may also be usefully employed. Either amine may be used alone or in combination. Generally, a small amount of the tertiary amine is used as an accelerator for the Jeffamine-(R). Excessive amounts of tertiary amine are not recommended since they tend to produce brittle cured products.

It is recommended that the polyoxyalkylene polyamine be used in approximately equivalent ratios to the epoxide, i.e. about 0.6-about 1.0 amine hydrogen atom per epoxide group.

By photocuring the inventive compositions in the UV inaccessible areas of an appropriate substrate, faster processing times and improved coating properties are obtained over compositions which rely exclusively on Michael addition or on a peroxy heat cure to polymerize the acrylic groups. Further, by using amines for which the Michael addition reaction is slow, a convenient two stage curing, long pot life product is obtained.

The invention is illustrated by the following nonlimiting examples.

EXAMPLES

Composition 1 was prepared as a two-part epoxy formulation. Mixing 4.8 parts by weight A to 1.0 part B gave a material with a pot life of 1 hour that was surface cured by exposure to high intensity UV light (100 mw/cm$^2$ for 20 seconds). Secondary cure via the amine after 24 hours at room temperature gave a product with the properties shown in the Tables.

## Composition 1

| Part A | Wt.% |
|---|---|
| Epoxy resin DGEBA (Dow Epoxy Resin 331) | 40.26 |
| Brominated epoxy resin (Dow Epoxy Resin 542) | 40.26 |
| Ethoxylated trimethylolpropane triacrylate (Sartomer Chemlink 176) | 17.71 |
| Diethoxyacetophenone | 1.77 |
| | 100.00 |

| Part B | |
|---|---|
| Polyoxypropylenediamine (Texaco Jeffamine D230) | 96.00 |
| Tris(dimethylaminomethyl)phenol | 4.00 |
| | 100.00 |

Composition 2 was prepared as a two-part epoxy formulation. Mixing 2 parts by volume A to 1 part B gave a material with a pot life of 1 hour that was surface cured by exposure to high intensity UV light (100 mw/cm$^2$ for 20 seconds). Secondary cure via the amine after 24 hours at room temperature gave a product with the properties shown in the Tables.

3

Composition 2

| Part A | Wt.% |
|---|---|
| Epoxy resin DGEBA (Dow Epoxy Resin 331) | 75.76 |
| Ethoxylated trimethylolpropane triacrylate (Sartomer Chemlink 176) | 21.21 |
| Diethoxyacetophenone | 3.03 |
| | 100.00 |

| Part B | Wt % |
|---|---|
| Polyoxypropylenediamine (Texaco Jeffamine D400) | 82.27 |
| Tris(dimethylaminomethyl)phenol | 17.73 |
| | 100.00 |

The above compositions were tested against three leading prior art compositions. Composition 3 contains a polyester polyisocyanate formulated with an acrylate monomer. It was cured by exposure to high intensity UV light (100 mw/cm$^2$ for 20 seconds) followed by secondary moisture cure from exposure to air at room temperature overnight. Composition 4 contains an acrylated urethane prepolymer which was cured with a primer. Composition 5 contains an acrylated urethane prepolymer formulated with an acrylate monomer. It was cured by exposure to high intensity UV light (100 mw/cm$^2$ for 20 seconds).

A series of poly(butyleneterephthalate) (Valox 420 SEO) lap shears were bonded to glass plates with compositions 1, 2, 3 and 4. Table 1 shows the generally superior adhesion and moisture resistance of the instant compositions 1 and 2 compared to the prior art compositions 3 and 4. All specimens were fully cured before exposure to the environments indicated. The specimens were allowed to cool to room temperature before testing at room temperature.

## Table 1

### Tensile Strength, psi

| | Comp.1 | Comp.2 | Comp.3 | Comp.4 |
|---|---|---|---|---|
| Initial Strength | 1341 | 1305 | 719 | 363 |
| 500 Hrs.Rm.Temp. | 1459 | 1297 | 765 | 197 |
| 250 Hrs. 37,8°C (100°F)/ Condensing Humidity | 755 | 1376 | 0 | 261 |
| 500 Hrs. 37,8°C (100°F)/ Condensing Humidity | 262 | 1179 | 0 | 288 |

A series of carbon-filled Valox$^{(R)}$ 420 SEO lap shears were bonded to glass plates as above. Table 2 shows that the superior performance of the instant compositions extends to carbon-filled Valox$^{(R)}$.

## Table 2
## Tensile Strength, psi

|  | Comp.2 | Comp.2 | Comp.3 | Comp.4 |
|---|---|---|---|---|
| Initial Strength | 991 | 996 | 722 | 230 |
| 500 Hrs.Rm.Temp. | 1321 | 1154 | 559 | 105 |
| 250 Hrs. 37,8°C (100°F)/ Condensing Humidity | 928 | 1155 | 0 | 154 |
| 500 Hrs. 37,8°C (100°F)/ Condensing Humidity | 488 | 976 | 0 | 112 |

Table 3 shows the results of various tests involving Composition 2, 3 and 5. A group of trimming potentiometers were potted with the compositions and cured as described above. Only instant Composition 2 passed all the tests.

Table 3

| Test | Comp.2 | Comp.3 | Comp.5 |
|---|---|---|---|
| Vapor degrease(1) | Pass | Pass | Fail |
| 2000 Hrs/150oC(2) | Pass | Pass | Pass |
| Thermal Shock, -65oC to 150 oC (3) | Pass | Fail | Fail |
| Biased power test, -70oC (4) | Pass | Fail | Fail |
| Solder Wave, 360oC, 3.5 sec. (5) | Pass | Pass | Pass |
| Florinert leakage, 125oC/60 sec.(6) | Pass | Fail | Fail |

(1)    Test involves 5 minutes exposure to Freon(R) TMS vapors.

(2)    Test involves 2000 hours at 150oC.

(3)    Test involves four cycles of thermal shock. Each cycle consists of 1/2 hour at -65oC, 5 minutes at room temperature. 1/2 hour at 150oC, and 5 minutes at room temperature.

(4)    Test involves continuous exposure to -70oC with power applied.

(5)    Test involves 3.5 seconds exposure to a 360oC solder wave. Note: On all tests, pass only without visible cracking, separation, or loss of adhesion.

(6)    Test requires no leakage path through the material when immersed in FluorinertTM (3M, FC-40) at 125oC for 60 seconds.

Claims

1. A two-part curable composition, characterised by first part comprising (a) a resin mixture comprising 60-95% of compounds having epoxy function groups and 5-40% of compounds having acrylate or methacrylate ester groups; and (b) 0.5-5% based on resin mixture weight of a free radical photoinitiator, and a second part comprising an amine component the amine being selected from those in which the amine-epoxy reaction is the predominant amine reaction.

2. A composition as in claim 1 characterised in that the amine component comprises 75-100% of polyoxyalkylene diamine and 0-25% of a tertiary amine.

3. A composition as in claim 2 characterised in that the polyoxyalkylene polyamine is selected from polyoxypropylene polyamines having average molecular weights between about 200 and 6500.

4. A composition as in claim 2 characterised by having a tertiary amine component where the tertiary amine component is 2,4,6-tri(dimethylaminomethyl)phenol.

5. A composition as in any of claims 1 to 4 characterised by one or more of the following features:
   (a) the (meth)-acrylate ester component comprises a (meth)-acrylate ester of a polyhydric alcohol;
   (b) the methacrylate ester component is present in the range of 15-30% by weight of the resin mixture;
   (c) the photoinitiator component is present in the range of 1-3% of the weight of the resin mixture; and
   (d) the epoxy functional compound is present in the range of 70-85% by weight in the resin mixture.

6. A composition as in any of claims 1 to 5 characterized in that the epoxy compound is a glycidyl polyether of a polyhydric phenol, preferably a glycidyl polyether of Bisphenol A.

7. A method of providing a cured coating or potting material on a substrate having shadow areas inaccessible to UV irradiation characterized by applying a mixture of the two parts of a composition as claimed in any of claims 1 to 6 to the substrate, including the shadow areas thereof, irradiating the composition of the substrate with UV light for sufficient time to immobilize the composition and then permitting the composition to completely cure under ambient conditions.

8. A method as in claim 7 characterised in that the substrate comprises an electronic circuit board or component.

9. A substrate characterised by being covered at least in part with the cured composition, the cured composition being applied by the method as claimed in claim 7.

10. A substrate as in claim 9 characterised by comprising an electronic circuit board or component.

**Revendications**

1. Composition durcissable à deux constituants, caractérisée par un premier constituant comprenant (a) un mélange de résine comprenant 60 à 95 % de composés ayant des groupes à fonction époxy et 5 à 40 % de composés ayant des groupes esters acryliques ou méthacryliques ; et (b) 0,5 à 5 %, par rapport au poids du mélange de résine, d'un photoamorceur radicalaire, et un second composant comprenant un constituant aminé, l'amine étant choisie parmi celles pour lesquelles la réaction amine-époxy est la réaction prédominante de l'amine.

2. Composition selon la revendication 1, caractérisée en ce que le constituant aminé comprend 75 à 100 % de polyoxyalkylène diamine et 0 à 25 % d'une amine tertiaire.

3. Composition selon la revendication 2, caractérisée en ce que la polyoxyalkylène polyamine est choisie parmi des polyoxypropylènes polyamines ayant des masses moléculaires moyennes comprises entre environ 200 et 6500.

4. Composition selon la revendication 2, caractérisée en ce qu'elle contient un constituant amine tertiaire dans lequel le constituant amine-tertiaire est le 2,4,6-tri(diméthylaminométhyl)phénol.

5. Composition selon l'une quelconque des revendications 1 à 4, caractérisée par une ou plusieurs des caractéristiques suivantes :
   (a) le constituant ester (méth)-acrylique comprend un ester (méth)-acrylique d'un polyalcool ;
   (b) le constituant ester méthacrylique est présent dans l'intervalle de 15 à 30 % en poids du mélange de résine ;

(c) le constituant photoamorceur est présent dans l'intervalle de 1 à 3 % du poids du mélange de résine ; et

(d) le composé à fonctionnalité époxy est présent dans l'intervalle de 70 à 85 % en poids du mélange de résine.

6. Composition selon l'une quelconque des revendications 1 à 5, caractérisé en ce que le composé époxy est un polyéther glycidylique d'un phénol polyvalent, de préférence un polyéther glycidylique du bisphénol A.

7. Procédé pour réaliser un revêtement ou une matière d'encapsulage durcie sur un substrat ayant des zones d'ombre inaccessibles au rayonnement UV, caractérisé en ce qu'on applique un mélange des deux composants d'une composition telle que revendiquée dans l'une quelconque des revendications 1 à 6 sur le substrat, y compris sur les zones d'ombre de celui-ci, en ce qu'on irradie la composition du substrat avec une lumière UV pendant un temps suffisant pour immobiliser la composition, puis en ce qu'on laisse la composition durcir complètement dans les conditions ambiantes.

8. Procédé selon la revendication 7, caractérisé en ce que le substrat comprend une plaque ou un composant de circuit électronique.

9. Substrat caractérisé en ce qu'il est recouvert au moins en partie par la composition durcie, la composition durcie étant appliquée par le procédé selon la revendication 7.

10. Substrat selon la revendication 9, caractérisé en ce qu'il comprend une plaque ou un composant de circuit électronique.

## Patentansprüche

1. Härtbare Zweikomponenten-Zusammensetzung, dadurch gekennzeichnet, daß die erste Komponente (a) ein Harzgemisch aus 60 bis 95 % Verbindungen mit funktionellen Epoxygruppen und 5 bis 40 % Verbindungen mit Acrylat- oder Methacrylat-Estergruppen und (b) 0,5 bis 5 %, bezogen auf das Gewicht des Harzgemisches, eines freie Radikale bildenden Fotoinitiators umfaßt und daß die zweite Komponente eine Amin-Komponente umfaßt, wobei das Amin aus denjenigen Aminen ausgewählt ist, bei denen die Amin-Epoxy-Reaktion die überwiegende Amin-Reaktion ist.

2. Zusammensetzung nach Anspruch 1, dadurch gekennzeichnet, daß die Amin-Komponente aus 75 bis 100 % Polyoxyalkylendiamin und 0 bis 25 % eines tertiären Amins besteht.

3. Zusammensetzung nach Anspruch 2, dadurch gekennzeichnet, daß das Polyoxyalkylenpolyamin aus Polyoxypropylenpolyaminen mit mittleren Molekulargewichten zwischen etwa 200 und 6500 ausgewählt ist.

4. Zusammensetzung nach Anspruch 2, dadurch gekennzeichnet, daß sie eine tertiäre Amin-Komponente aufweist, worin die tertiäre Amin-Komponente 2,4,6-Tri(dimethylaminomethyl)phenol ist.

5. Zusammensetzung nach einem der Ansprüche 1 bis 4, gekennzeichnet durch eines oder mehrere der folgenden Merkmale:

(a) die (Meth)acrylat-Esterkomponente umfaßt einen (Meth)acrylatester eines Polyhydroxyalkohols;

(b) die Methacrylat-Esterkomponente liegt in einer Menge im Bereich von 15 bis 30 %, bezogen auf das Gewicht des Harzgemisches, vor;

(c) die Fotoinitiator-Komponente liegt in einer Menge im Bereich von 1 bis 3 %, bezogen auf das Gewicht des Harzgemisches, vor; und

(d) die Epoxy-funktionelle Verbindung liegt in einer Menge im Bereich von 70 bis 85 %, bezogen auf das Gewicht des Harzgemisches, vor.

6. Zusammensetzung nach einem der Ansprüche 1 bis 5, dadurch gekennzeichnet, daß die Epoxy-Verbindung ein Glycidylpolyether eines Polyhydroxyphenols, vorzugsweise ein Glycidylpolyether von Bisphenol A, ist.

8

EP 0 245 559 B1

7. Verfahren zur Herstellung eines gehärteten Überzugs oder Einbettungsmaterials auf einem Substrat mit abgeschatteten Bereichen, die für UV-Bestrahlung unzugänglich sind, dadurch gekennzeichnet, daß ein Gemisch aus den zwei Komponenten der Zusammensetzung gemäß einem der Ansprüche 1 bis 6 auf das Substrat, einschließlich dessen abgeschatteter Bereiche, aufgetragen wird, die Zusammensetzung auf dem Substrat mit UV-Licht ausreichend lange bestrahlt wird, um die Zusammensetzung zu immobilisieren, und daß man dann die Zusammensetzung unter Umgebungsbedingungen vollständig aushärten läßt.

8. Verfahren nach Anspruch 7, dadurch gekennzeichnet, daß das Substrat eine elektronische Schaltungsplatte oder ein elektronisches Bauteil umfaßt.

9. Substrat, dadurch gekennzeichnet, daß es mindestens teilweise mit der gehärteten Zusammensetzung bedeckt ist, wobei die gehärtete Zusammensetzung durch das Verfahren gemäß Anspruch 7 gebildet worden ist.

10. Substrat nach Anspruch 9, dadurch gekennzeichnet, daß es eine elektronische Schaltungsplatte oder ein elektronisches Bauteil umfaßt.

9